# EUROPEAN PATENT SPECIFICATION

(11) **EP 1 574 594 B1**
(45) Date of publication and mention of the grant of the patent: **03.04.2013**
(21) Application number: 05405186.7
(22) Date of filing: 14.02.2005
(51) Int. Cl.: C23C 4/10, C23C 14/08, C23C 16/40, C30B 23/00, C30B 25/00, B23B 27/14

(54) **A carbon containing hard coating and a method for depositing a hard coating onto a substrate**
Eine kohlenstoffhaltige harte Beschichtung und ein Verfahren zur Beschichtung eines Substrats mit einer harten Beschichtung.
Revêtement dur comprenant du carbone et un procédé de dépôt d'un revêtement dur sur un substrat.

(30) Priority: 12.03.2004 EP 04405146
(43) Date of publication of application: 14.09.2005
(73) Proprietor: Sulzer Metaplas GmbH, 51427 Bergisch-Gladbach (DE)
(72) Inventor: Vetter, Jörg, 51469 Bergisch Gladbach (DE)
(74) Representative: Sulzer Management AG

(56) References cited:
- EP-A- 0 447 556
- EP-A- 0 701 982
- EP-A- 0 709 353
- EP-A- 1 316 627
- US-A- 5 580 653
- US-A1- 2003 143 402
- PATENT ABSTRACTS OF JAPAN vol. 2003, no. 09, 3 September 2003 (2003-09-03) & JP 2003 145317 A (MITSUBISHI MATERIALS CORP), 20 May 2003 (2003-05-20)
- VEPREK STAN: "The search for novel, superhard materials" JOURNAL OF VACUUM SCIENCE AND TECHNOLOGY A. VACUUM, SURFACES AND FILMS, AMERICAN INSTITUTE OF PHYSICS, NEW YORK, NY, US, vol. 17, no. 5, September 1999 (1999-09), pages 2401-2420, XP012004726 ISSN: 0734-2101

## Description

The invention relates to a carbon containing hard coating as well as to a method for depositing a hard coating onto a substrate in accordance with the preamble of the independent claim of the respective category.

In a variety of important applications e.g. in the field of cutting tools for milling, turning, or drilling, in the case of moulds or mechanical components like bearings, dies, rolls, or for example in the wide range of engine-components it is popular to coat hard coatings onto stressed surfaces in order to have superior wear resistance, oxidation behaviour, and friction properties.

Hard coatings containing titanium nitride are widely spread in a great variety of applications, wherein by adding carbon and aluminium forming TiₓAl_{y}N_{z} and / or TiₓC_{y}N_{z} chemical compounds, the hardness of titanium nitride coatings may be increased due to enhanced chemical bonding. In addition, the aforementioned MeCN compounds may be embedded into an amorphous-carbon phase reducing the friction coefficient of the hard coating.
Furthermore, it is well known that TiAIN has better oxidation resistance than TiN as a consequence of the formation of an aluminium passivation layer on the surface.

In particular in the field of high-speed-machining high frictional forces arise, especially if coated parts are pressed against each other by great forces causing additionally high temperatures as well as enormous longitudinal and transversal mechanical stress in the coating. The problem is, that known conventional hard coatings do not have at the same time a sufficient wear resistance, and a low friction coefficient, especially at higher temperatures, so that strong abrasion damages are caused in the coating after only a short time of operation.

It is therefore an object of the invention to provide an improved carbon containing hard coating as well as a method for depositing such a hard coating onto a surface of a substrate which hard coating has very high hardness, a low friction coefficient, high ductility and simultaneously an excellent strength against flaking-off and at the same time showing remarkably reduced residual stress, even at high temperatures.

The subject matter of the invention which satisfies this object is characterised by the features of the independent claims of the respective category.

The respective subordinate claims relate to particularly advantageous embodiments of the invention.

The carbon containing hard coating according to the invention comprises nano-crystalline grains being separated from each other by grain boundaries, wherein said hard coating comprises aluminium, at least one additional metal, carbon and at least one further element and has the chemical composition:

(AlₓMe1_{y}Me2_{z})CᵤE1ᵥE2_{w}

wherein Al is aluminium, Me1 is a metal, and Me2 is a metal, with x > 0.4 and x+y+z = 1 and y,z ≥ 0, and C is carbon and E1 and E2 are further chemical elements with 1 > u > 0 and u+v+w = 1 and v,w ≥ 0. The grain-boundaries have a higher concentration of carbon atoms than the nano-crystalline grains.

The hard coating according to the invention has a high hardness and is remarkably improved in low residual stress, has excellent strength against flaking-off and shows high reduction of stress relief of residual compression stress under high temperature, because carbon is not simply added to the hard coating but carbon is enriched at the grain boundaries of the nano-crystalline grains, that is the nano-crystalline grains are not simply embedded into an amorphous carbon phase as known from the state of the art. The carbon content in the grain boundaries is adjusted by controlling the pressure in the coating chamber and the temperature of the substrate to be coated, by controlling the kinetic energy of ions in the course of the coating process as well as by controlling the supply of carbon.

In addition, the hard coating in accordance with the present invention has also superior anti-oxidation properties due to the fact that the crystal grains are very fine that is they are of small size with a characteristic diameter of less than 50 nm, whereby in the frame of this patent application, the term "characteristic diameter" is referred to the diameter of a circle area which is calculated from an cross section area of the grains.

It is a new and surprising finding of the invention that a atomic concentration of aluminium greater than 0.4 with respect to the entire metal content results in improved properties of the hard coating in accordance with the invention, that is e.g. that the hard coating has improved friction properties and excellent strength against flaking-off. A very low friction coefficient of the coating is achieved because the grain boundaries are highly enriched with carbon resulting in an excellent self-lubricating behaviour.

According to a preferred embodiment, in Raman spectrum analysis the full width at half maximum of the Raman-lines between 1700 cm⁻¹ and 1000 cm⁻¹ is less than 150 cm⁻¹, preferred less than 100 cm⁻¹ which is especially, but not restricted to the case for hard coatings comprising metal carbo-nitride and / or carbo-oxi-nitride.

In a first preferred embodiment, the hard coating includes a metal carbo-oxide which is a chemical compound including at least one metal, carbon, and oxygen with E1 is oxygen and v > 0.

In a second embodiment, the hard coating according to the invention, includes a metal carbo-nitride, which is a chemical compound including at least one metal, carbon, and nitrogen with E2 is nitrogen and w > 0.

It is understood that in a special embodiment, the hard coating may include a metal carbo-oxi-nitride, which is a chemical compound comprising at least one metal, carbon, oxygen, and nitrogen.

The chemical component Me1 and / or Me2 may be an element of the 3^{rd} or 4^{th} main-group of the periodic table of the elements, and is especially boron and / or silicon, or a lanthanide, in particular, Me1 and / or Me2 may be an transition metal, especially iron and / or copper and / or chromium and / or manganese and / or scandium and I or yttrium and / or lanthanum, and / or molybdenum and / or tungsten and / or titanium and / or niobium and / or vanadium and / or tantalum and / or zirconium and / or hafnium.

In a further embodiment of a hard coating according to the invention the chemical compound E1 and / or E2 is lithium and / or beryllium and / or an element of the 6^{th} or 7^{th} main-group of the periodic table of the elements, especially sulphur and / or fluorine and / or chlorine.

In a preferred embodiment, the nano-crystalline grains in the hard coating according to the invention have a cubic structure, especially a cubic-face-centred structure, and / or have a hexagonal structure, especially a minor-hexagonal structure, whereby in the frame of this patent application, the term "minor-hexagonal structure" is referred to a crystallographic structure being essentially of cubic structure with small regions of hexagonal structure.

A characteristic diameter of the nano-crystalline grains is greater than 1 nm and less than 50 nm, preferably greater than 2 nm and less than 10 nm.

The cubic face-centred structure of the nano-crystalline grains can be clearly identified in electron-diffraction patterns taken by the well known transmission-electron-microscopy technique.

In contrast, the grain boundaries by which the nano-crystalline grains are separate from each other, are substantially of highly disordered structure resulting in typical electron-diffraction patterns showing broad and essentially unstructured diffraction lines, whereby the highly disordered grain boundaries may also include more or less ordered substructures.

Preferably but not necessarily, the hard coating of the present invention, has a multi-layer structure including at least 2 layers and at the most 2000 layers wherein the thickness of each layer is at least 2 nm and at the most 2000 nm

Regarding a special embodiment, the multi-layer structure includes an A-layer and a B-layer wherein the A-layer has a lower atomic concentration of carbon than the B-layer.

Furthermore, the B-layer may have a multi-layer structure including an C-layer and a D-layer wherein the C-layer has a lower atomic concentration of carbon than the D-layer, wherein the thickness of the C-layer and the D-layer is at least 2 nm and at the most 100 nm.

In another embodiment, the hard coating includes at least one layer and one amorphous like top-layer with an higher atomic concentration of carbon than said layer. In a special variation, the aforementioned layer includes at least 15% of carbon and at the most 75% of carbon, measured in atomic percent of non-metallic elements included in the hard coating.

Taking x-ray patterns of the hard coating in accordance with the invention, the full width at half Maximum of the (200)x-ray diffraction peak caused by an (200)-plane is at least 1° and at the most 4° at 2θ, especially at least 1.2° and at the most 1.9° at 2θ, wherein the value of an (200)-intensity (I[200]) of an (200)-peak caused by an (200)-plane, and an (111 )-Intensity (I[111]) of the (111 )-peak caused by an (111) plane, has preferably an intensity-ratio I[200]/I[111] of at least 1 and at the most of 15.

According to the invention, a method for depositing a hard coating is suggested, wherein said method is a physical-vapour-deposition technique, with the atomic concentration of carbon in the hard coating is preferred controlled by varying the flow rate of a oxygen and / or carbon including gas, like for example C₂H₂, in the course of the coating process.

A preferred method for depositing the hard coating is to sputter the hard coating onto a substrate by using a carbon containing sputter-target which is, in particular, very effective if an extremely low friction resistance of the hard coating is desired.

A combination of the aforementioned coating techniques, that is controlling the carbon content by varying the flow rate of a carbon including gas and, at the same time, using a carbon containing sputter-target, is also favourable.

It also favourable to introduce Argon into the coating chamber to generate Argon ions through plasma grow discharge to clean the substrate by Argon ion emission.

The carbon content in the grain boundaries can be adjusted for instance by controlling the pressure in the coating chamber, by controlling the kinetic energy of ions in the course of the coating process as well as by controlling the supply of carbon. Additionally, the temperature of the substrate to be coated may be adjusted by heating the substrate to a certain temperature, e.g. to a temperature between 550 °C and 650 °C, especially to a temperature of 575 °C.

In a special embodiment, a cathodic vacuum arc-evaporation method is used wherein before starting the coating process, the substrate is cleaned and preheated by bombarding the surface of the substrate with ions. Preferably, a protective atmosphere comprising argon and / or oxygen is present in the coating chamber. In the course of the coating process the temperature of the substrate is adjusted to a temperature between 500 °C and 650 °C, preferably to about 575 °C. The substrate is biased by a substrate power supply to a voltage in the range of 20V to 200V and the cathode current is in the range between 30 A and 200 A. During the coating process a gas comprising nitrogen and / or C₂H₂ is introduced into the coating chamber and the total pressure of the gas in the chamber is maintained in the pressure range between 0.5 Pascal and 5 Pascal. The flow of the gas is varied between 2 cm³/sec (sccm) and 200 cm³/sec (sccm).

Further methods in accordance with the invention for depositing a hard coating onto a substrate, are using an arc-plasma-deposition technique and / or using an electron-beam-evaporation technique and / or an chemical-vapour-deposition technique, especially a plasma-enhanced-chemical-vapour-deposition technique. It is understood, that every suitable combination of the aforementioned coating techniques may be applied to deposit the hard coating layer onto a substrate, for example to produce coatings having a multi-layer structure, wherein different layers may have different chemical compositions and / or different chemical and / or physical properties.

The above mentioned coating techniques are all well known to the person skilled in the art and are described in technical standard works and, therefore, need not to be described here in detail.

In the following, the invention will be explained in more detail with reference to the drawings. Shown are:
- Fig. 1:: Table 1 listing hard coatings according to the invention with different chemical compositions and different properties;
- Fig. 2:: a pattern of a Raman-spectrum analysis of a hard coating in accordance with the invention;
- Fig. 3:: a hard coating with a multi-layer structure and an amorphous-like top-layer.

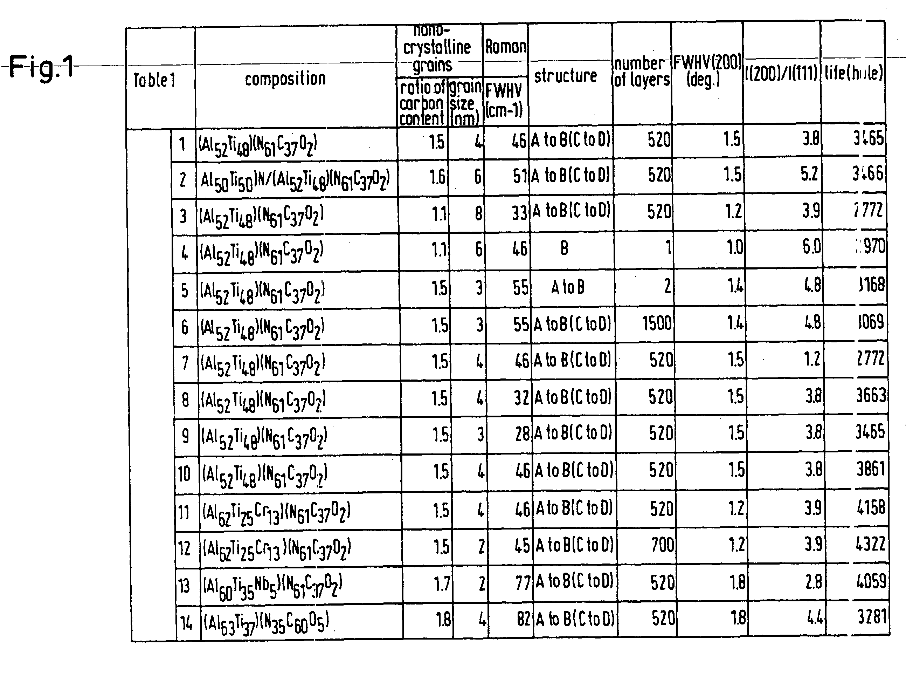

In Fig. 1 a listing of some examples of hard coatings 1 according to the present invention with different chemical compositions is given by Table 1, all having a multi-layer structure as indicated in column "structure" of Table 1, wherein e.g. B(C to D) means a B-layer having multi-layers of C-layer and D-layer. The number of layers of a given hard coating 1 varies between 1 (example 4) and 1500 (example 6).

According to the invention, the aluminium content of the hard coating 1 is greater than 0.4 with respect to the entire metal content of the hard coating 1. In the examples given in Table 1 the aluminium content in different hard coatings 1 is between 0.50 and 0.63. Please note that the proportion of a respective element in a certain composition in Table 1 is given in percent. That is for instance, (Al₅₂Ti₄₈) means that the composition includes 53% Al and 48% Ti. It is understood that the aluminium content of a hard coating 1 according to the invention can be less than 0.50 or more than 0.63. The examples of hard coatings 1 given in Table 1 are preferred embodiments of the present invention and it is a matter of course that further hard coatings 1 with other chemical compositions and / or chemical and / or physical properties are possible according to the claims and as disclosed in the description.

The carbon content in the grain boundaries is much greater than in the nano-crystalline grains itself. Column "ratio of carbon content" gives the ratio of the carbon content in grain boundaries in relation to the carbon content in the nano-crystalline grains. The ratios of carbon content given in Table 1 can be measured by a variety of well known different methods, for instance, but not only, by "electron energy loss spectroscopy" which is a very suitable method, especially for executing analysis of carbon contents in nano size dimensions. The electron-diffraction patterns taken from the grain boundaries show broad and essentially unstructured diffraction lines.

The results of Raman spectrum analysis shown in column "Raman", give the full width at half maximum (FWHM) of the Raman G-band, having values between 28 cm⁻¹ and 82 cm⁻¹, which is noticeable less than 100 cm⁻¹, which value is remarkably smaller in comparison with known amorphous like carbon layers. The respective Raman spectrum analysis were executed using an Argon-Ion-Laser equipment providing light of a wave length of 514,5 nm and having an output power of 1 mW and a laser beam diameter of 1 µm.

The full widths at half maximum of the (200)-x-ray diffraction peaks at 2Θ caused by (200)-planes are between 1.0 degree and 1.8 degree and the ratio of the(200)-intensities caused by an (200)-plane and the (111)-intensities caused by an (111) plane have a value between 1.2 and 6.8. The grain size, that is the characteristic diameter of grains in the respective hard coatings is for nearly all examples between 2 nm and 8 nm that is in most cases noticeable less than 10 nm.

In order to demonstrate the improves properties of the hard coating in accordance with the invention, cutting tests were carried out with 2-cutting edge drills which drills were provided with a hard coating as indicated in Table 1. A very good measure for the lifetime of a drill is the number of holes which can be machined before the drill loses his cutting ability.

Possible and typical drill cutting conditions which were used to determine the life of drills coated with a hard coating according to the invention are as follows:

| | |
|---|---|
| Tool | 2-cutting edge drill made of hard metal alloy |
| Diameter of Tool | O.D. 6mm |
| Substrate to be coated | WC-10 weight percent Co hard metal alloy |
| Cutting method | Blind hole machining |
| Material to be cut | SCM440 Steel DIN 1.7225 (42CrMo4) (30 HRC) |
| Depth of hole | 18 mm |
| Cutting speed | 150 m/min. |
| Feed rate | 0,3 mm/rev |
| Cutting oil | None. Air blow. |

The results of the respective cutting tests are summarised in the column "life (hole)" in Table 1, which gives the number of holes which can be machined by a single drill before the drill loses his cutting ability. The very large number of holes which can be machined by a single drill having a hard coating according to the present invention demonstrates very clearly the high hardness, the excellent strength against flaking-off and the improved properties under high temperature conditions.

In order to demonstrate the improved properties of the hard coating in accordance with the invention in comparison with the properties of a conventional hard coating known from the state of the art, a drill was coated by such a conventional hard coating having the chemical composition (Al₅₂Ti₄₈)(N₆₁C₃₇O₂) and having in the grain boundaries the same carbon content than in the nano-crystalline grains itself. That is, the "ratio of carbon content" which gives the ratio of the carbon content in grain boundaries in relation to the carbon content in the nano-crystalline grains equals to 1. The structure of the aforementioned conventional coating is a "A to B(C to D)" multi-layer structure comprising 520 layers and the full widths at half maximum of the (200)-x-ray diffraction peaks at 2Θ is 1.5 degree and the ratio of the(200)-intensity to the (111)-intensity is 3.8.

That is, with respect to the total chemical composition, the multi-layer-structure, and the above mentioned crystallographic properties of the nano-grains itself, the aforementioned coating is similar to the hard coating in accordance with the invention given in example 1 of Table 1.

The deciding difference between the known conventional coating and the hard coating in accordance with the invention is the very different carbon ratio as discussed above causing completely different properties of the respective coating.

The number of holes which can be machined by a single drill having the conventional coating, is only about 1200 holes before the drill loses his cutting ability. This is much less than the number of holes which can be machined by a drill having a hard coating in accordance with the invention. As very clearly indicated in Table 1, due to the improved properties of the hard coating of the present invention, that is especially due to the very high hardness, the excellent strength against flaking-off, and the improved resistance under high temperature conditions, the number of holes which can be machined by a hard coated drill amounts between 2772 and 4322 holes, that is the liftetime of the drill can be significantly increased in comparison to the lifetime of drill which has a conventional coating known from the state of the art.

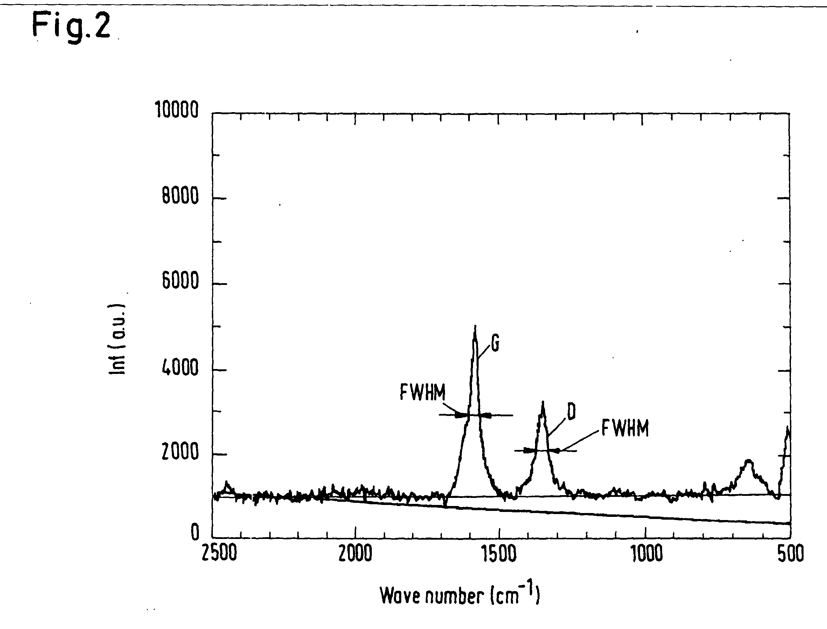

In Fig. 2 a typical pattern of a Raman-spectrum analysis of a hard coating 1 in accordance with the invention without an amorphous like top-layer T is presented. The two narrow, well separate lines G, D which are well known to the skilled person as G-band and D-band, respectively, are due to the nano-crystalline grains and prove their regular crystalline structure. Thus, the Raman spectrum analysis demonstrates clearly that nano-crystalline carbon grains are present in the hard coating in accordance with the invention.

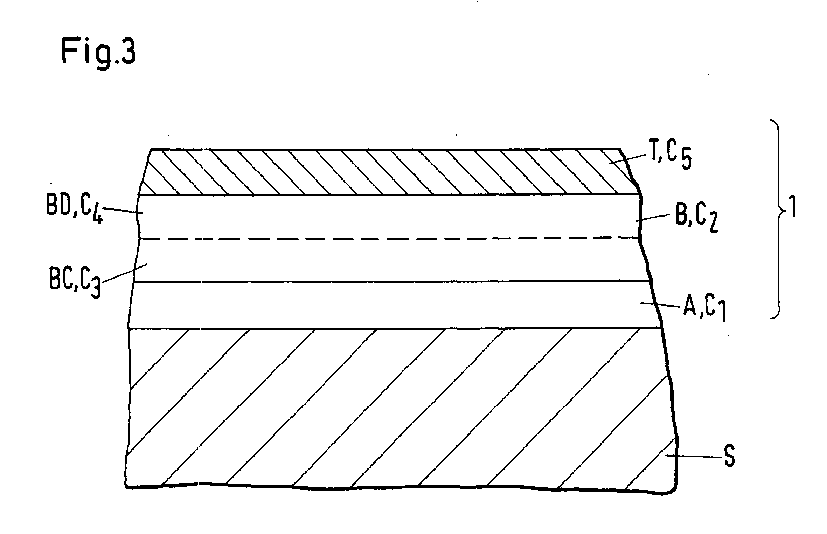

In Fig. 3, as a special embodiment of a hard coating 1 in accordance with the invention is presented having a multi-layer structure including a certain number of layers being coated on a substrate S, wherein the thickness of each layer is at least 2 nm and at the most 2000 nm. Regarding the special embodiment of Fig. 3, the multi-layer structure includes an A-layer A and a B-layer B wherein the A-layer A has a lower atomic concentration C₁ of carbon than the B-layer B having an atomic concentration C₂.

Furthermore, the B-layer B has a multi-layer structure including an C-layer BC and a D-layer BD wherein the C-layer BC has a lower atomic concentration C₃ of carbon than the atomic concentration C₄ of the D-layer BD, wherein the thickness of the C-layer BC and the D-layer BD is at least 2 nm and at the most 100 nm.

In addition, the hard coating 1 has an amorphous like top-layer T with an higher atomic concentration C₅ of carbon than all other layers. In a special variation, the aforementioned top-layer T includes at least 15% of carbon and at the most 75% of carbon, measured in atomic percent of non-metallic elements included in the hard coating.

Summarising, the hard coating according to the present invention has a suitable high hardness and is remarkably improved in low residual stress, has excellent strength against flaking-off and shows high reduction of stress relief of residual compression stress under high temperature with respect to the state of the art.

In addition, the hard coating in accordance with the present invention has also superior anti-oxidation properties due to the fact that the crystal grains are very fine that is they are of small size with a characteristic diameter of much less than 50 nm.

It is a new and surprising finding of the invention that a an atomic concentration of aluminium greater than 0.4 with respect to the entire metal content in combination with a higher carbon content in the grain boundaries than in the nano-grains itself, results in remarkably improved properties of the hard coating according to the invention, that is e.g. that the hard coating has improved friction properties and excellent strength against flaking-off. A very low friction coefficient of the coating is achieved because the grain boundaries are highly enriched with carbon resulting in an excellent self-lubricating behaviour.

## Claims

1. A carbon containing hard coating comprising nano-crystalline grains separated from each other by grain boundaries, said nano-crystalline grains comprising aluminium, at least one additional metal (Me1, Me2), carbon and at least one further element (E1, E2) and having the chemical composition:
(AlₓMe1_{y}Me2_{z})CᵤE1ᵥE2_{w}
wherein Me1 is a metal and Me2 is a metal and
with x > 0.4 and x+y+z = 1 and y,z ≥ 0 and
with 1 > u > 0 and u+v+w = 1 and v,w ≥ 0
**characterised in that** the grain-boundaries have a higher concentration of carbon atoms than the nano-crystalline-grains.

2. A hard coating according to Claim 1, wherein the full width at half maximum (FWHM) of the carbon Raman-lines (G, D) between 1700 cm⁻¹ and 1000 cm⁻¹ is less than 150 cm⁻¹, especially less than 100 cm⁻¹.

3. A hard coating according to Claim 1 or 2, wherein the hard coating includes a metal carbo-oxide with E1 is oxygen and v>0.

4. A hard coating according to anyone of the preceding Claims, wherein the hard coating includes metal carbo-nitride with E2 is nitrogen and w>0.

5. A hard coating according to anyone of the preceding Claims, wherein E1 and / or E2 is an element of group 16 or 17 of the periodic table of the elements.

6. A hard coating according to claim 5, wherein E1 and /or E2 are sulphur and / or fluorine and / or chlorine.

7. A hard coating according to anyone of the preceding claims, wherein Me1 and / or Me2 is lithium and / or beryllium and / or an element of group 13 or 14 of the periodic table of the elements, or a lanthanide.

8. A hard coating according to claim 7, wherein Me1 and /or Me2 are boron and / or silicon.

9. A hard coating according to anyone of the preceding Claims, wherein Me1 and / or Me2 is a transition metal,

10. A hard coating according to claim 9, wherein Me1 and /or Me2 are iron and / or copper and / or chromium and / or manganese and / or scandium and / or yttrium and / or lanthanum and / or molybdenum and / or tungsten and / or titanium and / or tantalum and / or niobium and / or vanadium and / or zirconium and / or hafnium.

11. A hard coating according to anyone of the preceding claims, wherein the nano-crystalline grains have a cubic structure.

12. A hard coating according to anyone of the preceding claims, wherein the nano-crystalline grains have a hexagonal structure.

13. A hard coating according to claim 12, wherein the hexagonal structure is a minor hexagonal structure.

14. A hard coating according to anyone of the preceding claims, wherein the grain boundaries are of highly disordered structure.

15. A hard coating according to anyone of the preceding claims, wherein a characteristic diameter of the nano-crystalline grains is greater than 1 nm and less than 50nm.

16. A hard coating according to claim 15, wherein the characteristic diameter of the nano-crystalline grains is greater than 2 nm and less than 10 nm.

17. A hard coating according to anyone of the preceding claims, having a multi-layer structure including at least 2 layers and at the most 2000 layers.

18. A hard coating according to Claim 17, wherein the thickness of each layer is at least 2 nm and at the most 2000 nm.

19. A hard coating according to anyone of the preceding claims, having a multi-layer structure including an A-layer (A) and a B-layer (B) wherein the A-layer (A) has a lower atomic concentration of carbon (C) than the B-layer (B).

20. A hard coating according to claim 19, wherein the B-layer has a multi-layer structure including an C-layer (BC) and a D-layer (BD) wherein the C-layer (BC) has a lower atomic concentration of carbon (C) than the D-layer (BD).

21. A hard coating according to claim 20, wherein the thickness of the C-layer (BC) and the D-layer (BD) is at least 2 nm and at the most 100 nm.

22. A hard coating according to anyone of the preceding claims, having at least one layer and one amophous like top-layer (T) with an higher atomic concentration of carbon (C) than said layer.

23. A hard coating according to anyone of the preceding claims, wherein the full width at half maximum of the (200)x-ray diffraction peak caused by an (200)-plane is at least 1° and at the most 4° at 28.

24. A hard coating according to claim 23, wherein the full width at half maximum of the (200)x-ray diffraction peak caused by an (200)-plane is at least 1.2° and at the most 1.9° at 2θ.

25. A hard coating according to anyone of the preceding claims, wherein an (200)-intensity (I[200]) of an (200)-peak caused by an (200)-plane, and an (111)-Intensity (I[111]) of the (111)-peak caused by an (111) plane, have a intensity-ratio (I[200]/[111]) of at least 1 and at the most of 15.

26. A method for depositing a hard coating (1) according to anyone of the preceding claims, wherein the hard coating is applied by a physical-vapour-deposition technique wherein the carbon content in the grain boundaries is adjusted by controlling the pressure in the coating chamber and the temperature of the substrate to be coated by controlling the kinetic energy of ions in the course of the coating process as well as by controlling the supply of carbon.

27. A method for depositing a hard coating (1) according to Claim 26, wherein the hard coating (1) is sputtered onto a substrate (S) by using a carbon containing sputter-target.

28. A method for depositing a hard coating (1) according to Claim 26 or 27, wherein the hard coating (1) is deposited onto the substrate (S) by using an arc-plasma-deposition technique.

29. A method for depositing a hard coating (1) according to anyone of claims 26 to 28, wherein the hard coating (1) is deposited onto the substrate (S) by using an electron-beam-evaporation technique.

30. A method for depositing a hard coating (1) according to anyone of claims 26 to 29, wherein the hard coating (1) is deposited onto the substrate (S) by an chemical-vapour-deposition technique.

31. A method for depositing a hard coating (1) according to anyone of claims 26 to 30, wherein the hard coating (1) is deposited onto the substrate (S) by an plasma-enhanced-chemical-vapour-deposition technique.

32. A method for depositing a hard coating (1) according to anyone of claims 26 to 31, wherein the atomic concentration of carbon (C) in the hard coating (1) is controlled by varying the flow rate of a oxygen (O) and / or carbon (C) including gas in the course of the coating process.

33. A method according to claim 32, wherein the gas is C₂H₂.

## Patentansprüche

1. Kohlenstoff enthaltende Hartbeschichtung, die nanokristalline Körner umfasst, die voneinander durch Korngrenzen getrennt sind, wobei die nanokristallinen Körner Aluminium, zumindest ein zusätzliches Metall (Me1, Me2), Kohlenstoff und zumindest ein weiteres Element (E1, E2) umfassen und die chemische Zusammensetzung aufweisen:
(AlₓMe1yMe2_{z})CᵤE₁ᵥE2_{w}
wobei Me 1 ein Metall ist und Me2 ein Metall ist und
wobei x > 0,4 und x+y+z = 1 sowie y, z ≥ 0 ist und
wobei 1 > u > 0 und u+v+w = 1 sowie v, w ≥ 0 ist,
**dadurch gekennzeichnet ,**
**dass** die Korngrenzen eine höhere Konzentration an Kohlenstoffatomen als die nanokristallinen Körner aufweisen.

2. Hartbeschichtung nach Anspruch 1,
wobei die Halbwertsbereite (FWHM) der Kohlenstoff-Ramanlinien (G, D) zwischen 1700 cm⁻¹ und 1000 cm⁻¹ kleiner als 150 cm⁻¹, insbesondere kleiner als 100 cm⁻¹ ist.

3. Hartbeschichtung nach Anspruch 1 oder 2,
wobei die Hartbeschichtung ein Metall-Kohlenstoffoxid aufweist, wobei E1 Sauerstoff ist und v > 0 ist.

4. Hartbeschichtung nach einem der vorstehenden Ansprüche,
wobei die Hartbeschichtung ein Metall-Kohlenstoffnitrid aufweist, wobei E2 Stickstoff ist und w > 0 ist.

5. Hartbeschichtung nach einem der vorstehenden Ansprüche,
wobei E1 und/oder E2 ein Element der Gruppe 16 oder 17 des Periodensystems der Elemente sind.

6. Hartbeschichtung nach Anspruch 5,
wobei E1 und/ oder E2 Schwefel und/oder Fluor und/oder Chlor sind.

7. Hartbeschichtung nach einem der vorstehenden Ansprüche,
wobei Me1 und/oder Me2 Lithium und/oder Beryllium und/oder ein Element der Gruppe 13 oder 14 des Periodensystems der Elemente oder ein Lanthanoid sind.

8. Hartbeschichtung nach Anspruch 7,
wobei Me1 und/oder Me2 Bor und/oder Silizium sind.

9. Hartbeschichtung nach einem der vorstehenden Ansprüche,
wobei Me1 und/oder Me2 ein Übergangsmetall ist.

10. Hartbeschichtung nach Anspruch 9,
wobei Me1 und/oder Me2 Eisen und/oder Kupfer und/oder Chrom und/oder Mangan und/oder Skandium und/oder Yttrium und/oder Lanthan und/oder Molybdän und/oder Wolfram und/oder Titan und/oder Tantal und/oder Niob und/oder Vanadium und/oder Zirkon und/oder Hafnium sind.

11. Hartbeschichtung nach einem der vorstehenden Ansprüche,
wobei die nanokristallinen Körner eine kubische Struktur aufweisen.

12. Hartbeschichtung nach einem der vorstehenden Ansprüche,
wobei die nanokristallinen Körner eine hexagonale Struktur aufweisen.

13. Hartbeschichtung nach Anspruch 12,
wobei die hexagonale Struktur eine untergeordnete hexagonale Struktur ist.

14. Hartbeschichtung nach einem der vorstehenden Ansprüche,
wobei die Korngrenzen von einer hochgradig ungeordneten Struktur sind.

15. Hartbeschichtung nach einem der vorstehenden Ansprüche,
wobei ein charakteristischer Durchmesser der nanokristallinen Körner größer als 1 mm und kleiner als 50 mm ist.

16. Hartbeschichtung nach Anspruch 15,
wobei der charakteristische Durchmesser der nanokristallinen Körner größer als 2 nm und kleiner als 10 nm ist.

17. Hartbeschichtung nach einem der vorstehenden Ansprüche,
die eine Mehrschichtstruktur mit zumindest zwei Schichten und höchstens 2000 Schichten aufweist.

18. Hartbeschichtung nach Anspruch 17,
wobei die Dicke jeder Schicht zumindest 2 nm und höchstens 2000 nm beträgt.

19. Hartbeschichtung nach einem der vorstehenden Ansprüche,
die eine Mehrschichtstruktur mit einer A-Schicht (A) und einer B-Schicht (B) aufweist, wobei die A-Schicht (A) eine geringere atomare Konzentration an Kohlenstoff (C) als die B-Schicht (B) aufweist.

20. Hartbeschichtung nach Anspruch 19,
wobei die B-Schicht eine Mehrschichtstruktur mit einer C-Schicht (BC) und einer D-Schicht (BD) aufweist, wobei die C-Schicht (BC) eine geringere atomare Konzentration an Kohlenstoff (C) als die D-Schicht (BD) aufweist.

21. Hartbeschichtung nach Anspruch 20,
wobei die Dicke der C-Schicht (BC) und der D-Schicht (BD) zumindest 2 nm und höchstens 100 nm beträgt.

22. Hartbeschichtung nach einem der vorstehenden Ansprüche,
die zumindest eine Schicht und zumindest eine amorph-ähnliche Oberschicht (T) mit einer höheren atomaren Konzentration an Kohlenstoff (C) als die Schicht aufweist.

23. Hartbeschichtung nach einem der vorstehenden Ansprüche,
wobei die Halbwertsbreite des (200)-Röntgenbeugungsmaximums, das durch eine (200)-Ebene verursacht wird, zumindest 1° und höchstens 4° bei 2θ beträgt.

24. Hartbeschichtung nach Anspruch 23,
wobei die Halbwertsbreite des (200)-Röntgenbeugungsmaximums, das durch eine (200)-Ebene verursacht wird, zumindest 1,2° und höchstens 1,9° bei 2θ beträgt.

25. Hartbeschichtung nach einem der vorstehenden Ansprüche,
wobei eine (200)-Intensität (I[200]) eines (200)-Maximums, das durch eine (200)-Ebene verursacht wird, und eine (111)-Intensität (I[111]) des (111)-Maximums, das durch eine (111)-Ebene verursacht wird, ein Intensitätsverhältnis (I[200]/I[111]) von zumindest 1 und von höchstens 15 aufweisen.

26. Verfahren zum Aufbringen einer Hartbeschichtung (1) nach einem der vorstehenden Ansprüche,
wobei die Hartbeschichtung durch eine physikalische Dampfphasen-Abscheidungstechnik aufgetragen wird, bei welcher der Kohlenstoffgehalt in den Korngrenzen durch Steuern des Drucks in der Beschichtungskammer und der Temperatur des zu beschichtenden Substrats eingestellt wird, indem die kinetische Energie von Ionen im Verlauf des Beschichtungsprozesses und auch die Zufuhr von Kohlenstoff gesteuert werden.

27. Verfahren zum Aufbringen einer Hartbeschichtung (1) nach Anspruch 26,
wobei die Hartbeschichtung (1) auf ein Substrat (S) gesputtert wird, indem ein Kohlenstoff enthaltendes Sputtertarget verwendet wird.

28. Verfahren zum Aufbringen einer Hartbeschichtung (1) nach Anspruch 26 oder 27,
wobei die Hartbeschichtung (1) unter Verwendung einer Lichtbogenplasma-Abscheidungstechnik auf das Substrat (S) aufgebracht wird.

29. Verfahren zum Aufbringen einer Hartbeschichtung (1) nach einem der Ansprüche 26 bis 28,
wobei die Hartbeschichtung (1) unter Verwendung einer Elektronenstrahl-Aufdampftechnik auf das Substrat (S) aufgebracht wird.

30. Verfahren zum Aufbringen einer Hartbeschichtung (1) nach einem der Ansprüche 26 bis 29,
wobei die Hartbeschichtung (1) durch eine chemische Dampfphasen-Abscheidungstechnik auf das Substrat (S) aufgebracht wird.

31. Verfahren zum Aufbringen einer Hartbeschichtung (1) nach einem der Ansprüche 26 bis 30,
wobei die Hartbeschichtung (1) durch eine chemische Dampfphasen-Abscheidungstechnik mit Plasmaätzen auf das Substrat (S) aufgebracht wird.

32. Verfahren zum Aufbringen einer Hartbeschichtung (1) nach einem der Ansprüche 26 bis 31,
wobei die atomare Konzentration an Kohlenstoff (C) in der Hartbeschichtung (1) gesteuert wird, indem die Strömungsrate eines Gases, das Sauerstoff (O) und/oder Kohlenstoff (C) enthält, in dem Verlauf des Beschichtungsprozesses variiert wird.

33. Verfahren nach Anspruch 32, wobei das Gas C₂H₂ ist.

## Revendications

1. Revêtement dur contenant du carbone comprenant des grains nanocristallins séparés les uns des autres par des joints de grains, lesdits grains nanocristallins comprenant de l'aluminium, au moins un métal supplémentaire (Me1, Me2), du carbone et au moins un autre élément (El, E2) et ayant la composition chimique :
(AlₓMe1_{y}Me2_{z}) CᵤE1ᵥE2_{w}
dans laquelle Me1 est un métal et Me2 est un métal, et
x > 0,4 et x + y + z = 1 et y,z ≥ 0 et
1 > u > 0 et u + v + w = 1 et v, w ≥ 0
**caractérisé en ce que** les joints de grains ont une concentration plus élevée en atomes de carbone que les grains nanocristallins.

2. Revêtement dur selon la revendication 1, dans lequel la largeur totale à mi-hauteur (LTMH) des lignes Raman du carbone (G, D) entre 1700 cm⁻¹ et 1000 cm⁻¹ est inférieure à 150 cm⁻¹, en particulier inférieure à 100 cm⁻¹.

3. Revêtement dur selon la revendication 1 ou 2, le revêtement dur comprenant un carbo-oxyde de métal, E1 étant un atome d'oxygène et v > 0.

4. Revêtement dur selon l'une quelconque des revendications précédentes, le revêtement dur comprenant un carbo-nitrure de métal, E2 étant un atome d'azote et w > 0.

5. Revêtement dur selon l'une quelconque des revendications précédentes, dans lequel E1 et/ou E2 est/sont un élément du groupe 16 ou 17 du tableau périodique des éléments.

6. Revêtement dur selon la revendication 5, dans lequel E1 et/ou E2 est/sont un atome de soufre et/ou de fluor et/ou de chlore.

7. Revêtement dur selon l'une quelconque des revendications précédentes, dans lequel Me1 et/ou Me2 est/sont le lithium et/ou le béryllium et/ou un élément du groupe 13 ou 14 du tableau périodique des éléments, ou un lanthanide.

8. Revêtement dur selon la revendication 7, dans lequel Me1 et/ou Me2 est/sont le bore et/ou le silicium.

9. Revêtement dur selon l'une quelconque des revendications précédentes, dans lequel Me1 et/ou Me2 est/sont un métal de transition.

10. Revêtement dur selon la revendication 9, dans lequel Me1 et/ou Me2 est/sont le fer et/ou le cuivre et/ou le chrome et/ou le manganèse et/ou le scandium et/ou l'yttrium et/ou le lanthane et/ou le molybdène et/ou le tungstène et/ou le titane et/ou le tantale et/ou le niobium et/ou le vanadium et/ou le zirconium et/ou le hafnium.

11. Revêtement dur selon l'une quelconque des revendications précédentes, dans lequel les grains nanocristallins ont une structure cubique.

12. Revêtement dur selon l'une quelconque des revendications précédentes, dans lequel les grains nanocristallins ont une structure hexagonale.

13. Revêtement dur selon la revendication 12, dans lequel la structure hexagonale est une structure hexagonale mineure.

14. Revêtement dur selon l'une quelconque des revendications précédentes, dans lequel les joints de grains ont une structure très désordonnée.

15. Revêtement dur selon l'une quelconque des revendications précédentes, dans lequel un diamètre caractéristique des grains nanocristallins est supérieur à 1 nm et inférieur à 50 nm.

16. Revêtement dur selon la revendication 15, dans lequel le diamètre caractéristique des grains nanocristallins est supérieur à 2 nm et inférieur à 10 nm.

17. Revêtement dur selon l'une quelconque des revendications précédentes, ayant une structure multicouche incluant au moins 2 couches et au plus 2000 couches.

18. Revêtement dur selon la revendication 17, dans lequel l'épaisseur de chaque couche est d'au moins 2 nm et d'au plus 2000 nm.

19. Revêtement dur selon l'une quelconque des revendications précédentes, ayant une structure multicouche incluant une couche A (A) et une couche B (B), la couche A (A) ayant une concentration atomique en carbone (C) inférieure celle de la couche B (B).

20. Revêtement dur selon la revendication 19, dans lequel la couche B a une structure multicouche incluant une couche C (BC) et une couche D (BD), la couche C (BC) ayant une concentration atomique en carbone (C) inférieure à celle de la couche D (BD).

21. Revêtement dur selon la revendication 20, dans lequel l'épaisseur de la couche C (BC) et de la couche D (BD) est d'au moins 2 nm et d'au plus 100 nm.

22. Revêtement dur selon l'une quelconque des revendications précédentes, ayant au moins une couche et une couche de finition de type amorphe (T) ayant une concentration atomique en carbone (C) supérieure à celle de ladite couche.

23. Revêtement dur selon l'une quelconque des revendications précédentes, dans lequel la largeur totale à mi-hauteur du pic de diffraction des rayons X (200) provoquée par un plan (200) est d'au moins 1° et d'au plus 4° à 2θ.

24. Revêtement dur selon la revendication 23, dans lequel la largeur totale à mi-hauteur du pic de diffraction des rayons X (200) provoquée par un plan (200) est d'au moins 1,2° et d'au plus 1,9° à 2θ.

25. Revêtement dur selon l'une quelconque des revendications précédentes, dans lequel une intensité (200) (I[200]) d'un pic (200) provoquée par un plan (200) et une intensité (111) (I[111]) du pic (111) provoquée par un plan (111) ont un rapport d'intensité (I[200]/I[111]) d'au moins 1 et d'au plus 15.

26. Procédé de dépôt d'un revêtement dur (1) selon l'une quelconque des revendications précédentes, dans lequel le revêtement dur est appliqué par une technique de dépôt physique en phase vapeur dans laquelle la teneur en carbone dans les joints de grains est ajustée par le contrôle de la pression de la chambre de revêtement et de la température du substrat à revêtir par le contrôle de l'énergie cinétique des ions pendant le procédé de revêtement, ainsi que par le contrôle de l'alimentation du carbone.

27. Procédé de dépôt d'un revêtement dur (1) selon la revendication 26, dans lequel le revêtement dur (1) est pulvérisé sur un substrat (S) en utilisant une cible de pulvérisation contenant du carbone.

28. Procédé de dépôt d'un revêtement dur (1) selon la revendication 26 ou 27, dans lequel le revêtement dur (1) est déposé sur le substrat (S) en utilisant une technique de dépôt par plasma d'arc.

29. Procédé de dépôt d'un revêtement dur (1) selon l'une quelconque des revendications 26 à 28, dans lequel le revêtement dur (1) est déposé sur le substrat (S) en utilisant une technique d'évaporation par faisceau électronique.

30. Procédé de dépôt d'un revêtement dur (1) selon l'une quelconque des revendications 26 à 29, dans lequel le revêtement dur (1) est déposé sur le substrat (S) en utilisant une technique de dépôt chimique en phase vapeur.

31. Procédé de dépôt d'un revêtement dur (1) selon l'une quelconque des revendications 26 à 30, dans lequel le revêtement dur (1) est déposé sur le substrat (S) en utilisant une technique de dépôt chimique en phase vapeur activé par plasma.

32. Procédé de dépôt d'un revêtement dur (1) selon l'une quelconque des revendications 26 à 31, dans lequel la concentration atomique en carbone (C) dans le revêtement dur (1) est contrôlée en faisant varier le débit d'un gaz contenant de l'oxygène (O) et/ou du carbone (C) pendant le procédé de revêtement.

33. Procédé selon la revendication 32, dans lequel le gaz est C₂H₂.
